# FASCICULE DE BREVET EUROPEEN

(11) **EP 2 546 988 B1**
(45) Date de publication et mention de la délivrance du brevet: **23.09.2015**
(21) Numéro de dépôt: 12175234.9
(22) Date de dépôt: 06.07.2012
(51) Int. Cl.: H03K 17/567, H03K 17/691

(54) **Circuit de commande d'un circuit électrique de puissance en fonction d'impulsions de commande**
Steuerungsschaltkreis eines elektrischen Leistungsschaltkreises in Steuerimpulsfunktion
Circuit for controlling an electric power circuit according to control pulses

(30) Priorité: 11.07.2011 FR 1102175
(43) Date de publication de la demande: 16.01.2013
(73) Titulaire: Airbus Defence and Space SAS, 78130 Les Mureaux (FR)
(72) Inventeur: Loréa, Marc, 91160 LONGJUMEAU (FR)
(74) Mandataire: Ribeiro Dias, Alexandre

(56) Documents cités:
- US-A- 5 051 609
- US-A- 6 087 862
- US-A1- 2009 230 938
- US-A1- 2011 012 542
- US-B1- 6 777 827

## Description

### DOMAINE TECHNIQUE

La présente invention appartient au domaine des circuits électriques de puissance, et concerne plus particulièrement un circuit de commande mis en oeuvre pour commander un circuit électrique de puissance en fonction d'impulsions délivrées par un circuit générateur d'impulsions.

### ÉTAT DE LA TECHNIQUE

En pratique, de tels circuits de commande sont notamment mis en oeuvre pour adapter les niveaux de tension/courant, généralement bas et délivrés par le circuit générateur d'impulsions (qui comporte généralement un processeur - DSP, etc. - et/ou un circuit logique programmable - FPGA, etc.) aux niveaux de tension/courant, généralement plus élevés et référencés à une masse électrique différente de celle du circuit générateur d'impulsions, requis pour commander le circuit électrique de puissance, dit « circuit à commander ».

En outre, de tels circuits de commande doivent permettre de maintenir un signal de commande au circuit à commander, associé à une impulsion de commande reçue du circuit générateur d'impulsions, même après la fin de cette impulsion et ce jusqu'à l'impulsion de commande suivante, lesdites impulsions étant généralement générées de façon périodique.

Lesdites impulsions de commande peuvent par exemple prendre deux valeurs, telles que ±V0, associées à des signaux de commande distincts à appliquer au circuit à commander. Lors de la réception d'une impulsion de commande, par exemple de valeur +V0, le signal de commande associé à la valeur +V0 doit être maintenu jusqu'à la réception de l'impulsion suivante, c'est-à-dire y compris après la fin de ladite impulsion de valeur +V0.

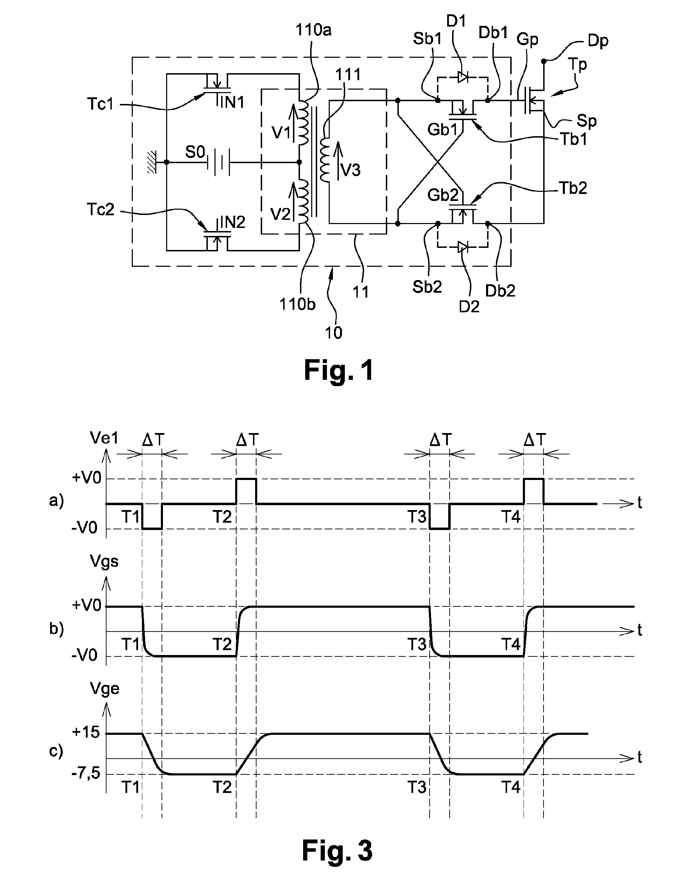

La figure 1 représente schématiquement un exemple connu de circuit de commande 10 mis en oeuvre pour commander la commutation d'un transistor MOSFET de puissance, dit « transistor de puissance » Tp.

Dans cet exemple, le circuit de commande comporte un transformateur 11 comportant un premier enroulement primaire 110a, un second enroulement primaire 110b et un enroulement secondaire 111.

Les premier et second enroulements primaires 110a, 110b comportent chacun deux bornes, dont une commune qui est reliée à une source de tension électrique S0 délivrant une tension de valeur V0. L'autre borne de chacun desdits premier et second enroulements primaires 110a, 110b est reliée à la masse électrique par l'intermédiaire de deux transistors MOSFET, désignés respectivement par « premier transistor de commande » Tc1 et par « second transistor de commande » Tc2.

Des électrodes de grille desdits premiers et second transistors de commande Tc1 et Tc2, désignées respectivement par IN1 et IN2, sont par exemple reliées à un dispositif électronique de commande non représenté, tel qu'un DSP, un FPGA, etc.

Le dispositif électronique de commande génère des impulsions de tension prédéfinie, et applique ces impulsions soit sur l'électrode de grille IN1, pour rendre passant le premier transistor de commande Tc1, soit sur l'électrode de grille IN2, pour rendre passant le second transistor de commande Tc2.

Du côté de l'enroulement secondaire 111, le circuit de commande 10 comprend un étage à bascule comportant deux transistors MOSFET, désignés respectivement par « premier transistor de bascule » Tb1 et par « second transistor de bascule » Tb2.

Le premier transistor de bascule Tb1 comporte une électrode de source Sb1 reliée directement à une première borne de l'enroulement secondaire 111, une électrode de drain Db1 reliée à une électrode de grille Gp du transistor de puissance Tp, et une électrode de grille Gb1 reliée à une seconde borne de l'enroulement secondaire 111.

Le second transistor de bascule Tb2 comprend une électrode de source Sb2 reliée directement à la seconde borne de l'enroulement secondaire 111, une électrode de drain Db2 reliée à une électrode de source Sp du transistor de puissance Tp, et une électrode de grille Gb2 reliée à la première borne de l'enroulement secondaire 111.

En outre l'électrode de source Sb1 du premier transistor de bascule Tb1 est reliée à l'électrode de grille Gb2 du second transistor de bascule Tb2, et l'électrode de source Sb2 du second transistor de bascule Tb2 est reliée à l'électrode de grille Gb1 du premier transistor de bascule Tb1.

Lorsqu'une impulsion est appliquée sur une électrode de grille IN1 du premier transistor de commande Tc1, la tension V1 aux bornes du premier enroulement primaire 110a prend la valeur +V0.

La tension V3 aux bornes de l'enroulement secondaire 111 est alors de valeur positive et place le second transistor de bascule Tb2 dans un état passant (commutateur fermé). L'électrode de grille Gp du transistor de puissance Tp se charge alors par l'intermédiaire d'une diode D1 entre l'électrode de source Sb1 et l'électrode de drain Db1 du premier transistor de bascule Tb1 (pouvant être soit une diode intrinsèque drain-source du premier transistor de bascule Tb1, soit un composant discret additionnel tel qu'une diode de Schottky).

Ainsi la tension Vgs entre l'électrode de grille Gp du transistor de puissance Tp et son électrode de source Sp est de valeur positive, plaçant ledit transistor de puissance Tp dans un état passant (commutateur fermé).

Lorsqu'une impulsion est appliquée sur l'électrode de grille IN2 du second transistor de commande Tc2, la tension V2 aux bornes du second enroulement primaire 110b prend la valeur -V0.

La tension V3 est alors de valeur négative et place le premier transistor de bascule Tb1 dans un état passant. L'électrode de source Sp du transistor de puissance Tp se charge alors par l'intermédiaire d'une diode D2 entre l'électrode de source Sb2 et l'électrode de drain Db2 du second transistor de bascule Tb2 (interne ou externe audit second transistor de bascule Tb2).

Ainsi la tension Vgs entre l'électrode de grille Gp du transistor de puissance Tp et son électrode de source Sp est de valeur négative, plaçant ledit transistor de puissance dans un état non passant (commutateur ouvert).

A la fin d'une impulsion générée par le dispositif électrique, les tensions V1, V2 et V3 prennent une valeur sensiblement nulle. Le premier transistor de bascule Tb1 et le second transistor de bascule Tb2 sont alors tous deux dans un état non passant, de sorte que le transistor de puissance Tp est déconnecté de l'enroulement secondaire 111.

Du fait de cette déconnexion, la valeur de la tension Vgs, préalablement appliquée sur ledit transistor de puissance Tp, est mémorisée sur le condensateur d'entrée dudit transistor de puissance Tp (connu sous le nom de condensateur grille-source Cgs).

Du fait de cette mémorisation de la valeur de la tension Vgs sur le condensateur grille-source Cgs, le transistor de puissance Tp reste, en l'absence d'impulsion au niveau des enroulements primaires, dans l'état dans lequel il a été placé par la dernière impulsion appliquée au niveau desdits enroulements primaires.

Toutefois, le circuit de commande 10 illustré par la figure 1 présente de nombreuses limitations.

Tout d'abord, dans le cas d'un transistor de puissance Tp de forte charge totale d'électrode de grille (par exemple supérieure à 100 nano-coulombs), l'enroulement secondaire 111 du transformateur 11 et le condensateur grille-source Cgs peuvent entrainer un phénomène de résonance qui s'oppose à un transfert efficace de l'énergie du transformateur 11 vers le transistor de puissance Tp, et par conséquent qui s'oppose à la commutation rapide dudit transistor de puissance Tp.

Ensuite, des fluctuations de la tension entre une électrode de drain Dp et l'électrode de source Sp du transistor de puissance Tp peuvent influencer la valeur de la tension Vgs par l'intermédiaire d'un condensateur parasite entre l'électrode de drain Dp et l'électrode de grille Gp du transistor de puissance Tp.

D'autres exemples de tels circuits connus sont divulgués dans US 5,051,606 et US 6,777,827.

### EXPOSÉ DE L'INVENTION

La présente invention vise à résoudre tout ou partie des problèmes susmentionnés.

En outre, la présente invention vise à proposer un circuit de commande adapté à commander plusieurs types de circuits électriques de puissance. Notamment, la présente invention a pour objectif de proposer une solution qui permette de commander la commutation de tout type de transistor de puissance : bipolaire, à effet de champ, à grille isolée (MOSFET, IGBT - « Insulated Gate Bipolar Transistor » -, etc.), etc.

En outre, la présente invention vise à proposer une solution qui puisse être réalisée avec un nombre limité de composants discrets, et qui soit préférentiellement adaptée à une mise en oeuvre pour des applications durcies à l'environnement nucléaire naturel (par exemple pour des applications spatiales telles que la commande de moteurs électriques d'actionneurs inertiels du type roues de réaction ou volants d'inertie) ou artificiel.

Selon un premier aspect, l'invention concerne un circuit de commande d'un circuit électrique de puissance, dit « circuit à commander », comportant un étage, dit « étage de connexion/déconnexion » comportant :
- un port d'entrée destiné à être couplé à un circuit générateur d'impulsions de commande pouvant prendre au moins deux valeurs prédéfinies associées à des signaux de commande distincts à appliquer au circuit à commander,
- un port de sortie, et
- des moyens configurés pour connecter son port de sortie à son port d'entrée lorsqu'une impulsion de commande est appliquée sur ledit port d'entrée, et configurés pour déconnecter son port de sortie de son port d'entrée lorsqu'aucune impulsion de commande n'est appliquée sur ledit port d'entrée.

Le circuit de commande comporte en outre un étage, dit « étage de mémorisation », comportant :
- un premier transistor MOSFET et un second transistor MOSFET, respectivement de type N et de type P, des électrodes de grille desdits premier et second transistors MOSFET étant reliées directement entre elles, et des électrodes de source desdits premier et second transistors MOSFET étant reliées directement entre elles,
- un port d'entrée, couplé au port de sortie de l'étage de connexion/déconnexion, comportant deux bornes dont l'une est couplée aux électrodes de grille et l'autre est couplée aux électrodes de source des premier et second transistors MOSFET,
- un port de sortie destiné à être couplé au circuit à commander,
de sorte que, pendant une déconnexion de l'étage de connexion/déconnexion :
- un signal appliqué par ledit étage de connexion/déconnexion juste avant ladite déconnexion est mémorisé sur le port d'entrée de l'étage de mémorisation,
- un signal de commande, associé au signal mémorisé et reçu par des électrodes de drain des premier et second transistors MOSFET, est appliqué sur le port de sortie de l'étage de mémorisation tant que ledit signal est mémorisé.

Suivant des modes particuliers de réalisation, le circuit de commande comporte l'une ou plusieurs des caractéristiques suivantes, prises isolément ou suivant toutes les combinaisons techniquement possibles.

Dans un mode particulier de réalisation, l'étage de mémorisation comporte au moins un condensateur comportant deux bornes : une première borne couplée aux électrodes de grille des premier et second transistors MOSFET et une seconde borne couplée aux électrodes de source desdits premier et second transistors MOSFET.

Dans un mode particulier de réalisation, l'étage de connexion/déconnexion est un étage à bascule à base de transistors.

Dans un mode particulier de réalisation, l'étage à bascule comporte deux montages de transistors de type Sziklai ou Darlington.

Dans un mode particulier de réalisation, l'étage à bascule comporte deux ponts diviseurs de tension, chaque pont diviseur étant adapté à ne permettre la connexion de l'étage de mémorisation que si la tension aux bornes de l'enroulement secondaire du transformateur est de valeur absolue supérieure à une valeur seuil prédéfinie.

Dans un mode particulier de réalisation, l'étage à bascule est à base de transistors bipolaires.

Dans un mode particulier de réalisation, l'étage de mémorisation comporte un port d'alimentation, formé par les électrodes de drain des premier et second transistors MOSFET, destiné à être couplé à au moins une source d'alimentation électrique pour la formation des signaux de commande à appliquer au circuit à commander.

Dans un mode particulier de réalisation, le circuit commande comporte un transformateur comportant au moins un enroulement primaire destiné à être couplé au circuit générateur d'impulsions de commande, et un enroulement secondaire couplé au port d'entrée de l'étage de connexion/déconnexion.

Selon un second aspect, l'invention concerne un dispositif électrique comportant un circuit générateur d'impulsions de commande, un circuit électrique de puissance, dit « circuit à commander », et un circuit de commande selon l'invention.

Suivant des modes particuliers de réalisation, le dispositif électrique comporte l'une ou plusieurs des caractéristiques suivantes, prises isolément ou suivant toutes les combinaisons techniquement possibles.

Dans un mode particulier de réalisation, le circuit à commander est du type comportant au moins un transistor de puissance mis en oeuvre comme commutateur, dont l'ouverture et la fermeture sont commandées par le circuit de commande.

Dans un mode particulier de réalisation, le transistor de puissance est un transistor à grille isolée, et l'étage de mémorisation comporte au moins un composant résistif de valeur suffisante pour assurer qu'une durée de charge ou de décharge dudit transistor de puissance est égale ou supérieure à une durée minimale prédéfinie de contrôle de la commutation dudit transistor de puissance.

Dans un mode particulier de réalisation, le circuit à commander est une alimentation à découpage.

### PRÉSENTATION DES FIGURES

L'invention sera mieux comprise à la lecture de la description suivante, donnée à titre d'exemple nullement limitatif, et faite en se référant aux figures suivantes, dans lesquelles des références identiques désignent des éléments identiques ou analogues, qui représentent :
- Figure 1 : une représentation schématique d'un circuit de commande selon l'art antérieur,
- Figure 2 : une représentation schématique d'un circuit de commande selon l'invention, mis en oeuvre pour commander la commutation d'un transistor de puissance,
- Figure 3 : un chronogramme illustrant de façon schématique le fonctionnement du circuit de commande selon l'invention,
- Figures 4a et 4b : des représentations schématiques illustrant la mise en oeuvre d'un circuit de commande selon l'invention pour commander des alimentations à découpage, respectivement une alimentation de type hacheur abaisseur et une alimentation de type hacheur élévateur.

### DESCRIPTION DÉTAILLÉE DE MODES DE RÉALISATION

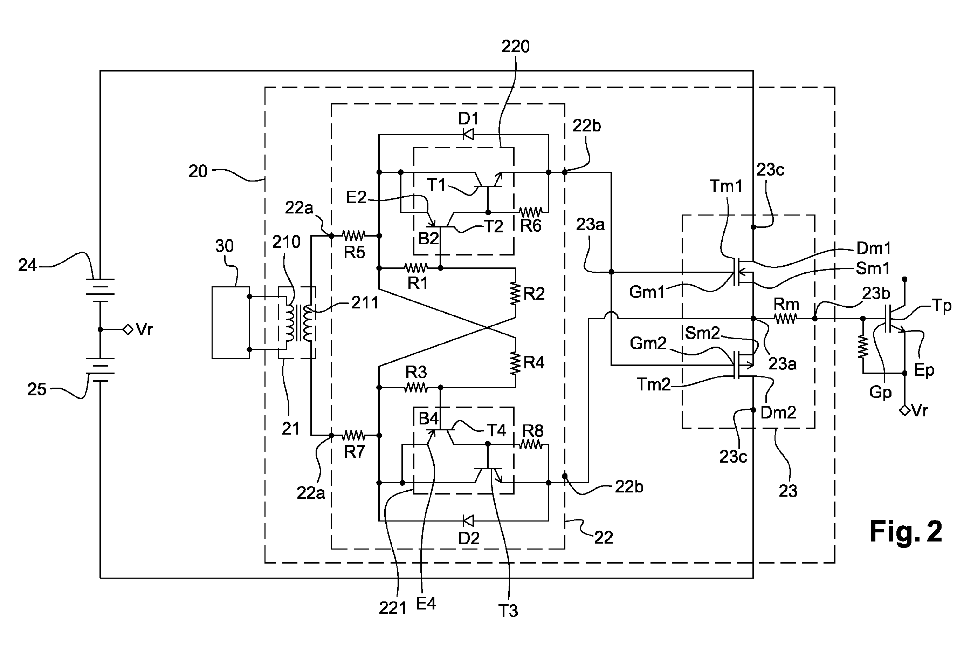

La figure 2 représente de façon schématique un mode préféré de réalisation d'un circuit de commande 20 selon l'invention, mis en oeuvre pour commander un circuit électrique de puissance, dit « circuit à commander ». Dans l'exemple illustré par la figure 2, le circuit à commander est un transistor de puissance Tp de type IGBT (« Insulated Gate Bipolar Transistor »).

Dans ce mode de réalisation, le circuit de commande 20 comporte de préférence un transformateur 21 comportant un enroulement primaire 210 et un enroulement secondaire 211. Rien n'exclut, suivant d'autres exemples non représentés, d'avoir un transformateur 21 avec plusieurs enroulements primaires, comme c'est le cas dans le transformateur de la figure 1.

L'utilisation du transformateur 21 est avantageuse car elle assure notamment une isolation galvanique entre, d'une part, un circuit générateur 30 d'impulsions de commande couplé à l'enroulement primaire 210 et, d'autre part, le circuit à commander (transistor de puissance Tp). En outre, l'utilisation du transformateur 21 permet également de commander un circuit à commander (transistor de puissance Tp) flottant, c'est-à-dire non référencé à la masse électrique du circuit générateur d'impulsions 30.

La réalisation du circuit générateur 30 d'impulsions de commande sort du cadre de l'invention. De manière générale, ledit circuit générateur 30 peut être de tout type adapté à générer des impulsions de commande pouvant prendre au moins deux valeurs prédéfinies associées à des signaux de commande distincts à appliquer au transistor de puissance Tp (lesdits signaux de commande distincts correspondant à des états différents dans lesquels le transistor de puissance Tp peut être placé par le circuit de commande 20).

De manière nullement limitative de l'invention, on se place dans le cas où le circuit générateur 30 génère une impulsion de commande de valeur +V0 lorsque le transistor de puissance Tp doit être placé dans un état passant (commutateur fermé), et génère une impulsion de commande de valeur -V0 lorsque le transistor de puissance Tp doit être placé dans un état non-passant (commutateur ouvert). En l'absence d'impulsion de commande, la tension aux bornes de l'enroulement primaire 210 est sensiblement nulle.

L'enroulement secondaire 211 du transformateur 21 est couplé à un premier étage, dit « étage de connexion/déconnexion » 22.

L'étage de connexion/déconnexion 22 comporte un port d'entrée 22a, couplé audit enroulement secondaire 211, et un port de sortie 22b.

L'étage de connexion/déconnexion 22 comporte en outre des moyens configurés pour connecter son port de sortie 22b à son port d'entrée 22a lorsqu'une impulsion de commande (tension sensiblement égale à ±V0) est appliquée sur l'enroulement primaire 210, et configurés pour déconnecter son port de sortie 22b de son port d'entrée 22a lorsqu'aucune impulsion de commande (tension sensiblement nulle) n'est appliquée sur l'enroulement primaire 210.

De manière générale, les moyens de connecter/déconnecter de l'étage de connexion/déconnexion 22 peuvent prendre toute forme adaptée connue de l'homme de l'art.

Dans le mode préféré de réalisation illustré par la figure 2, lesdits moyens de connecter/déconnecter le port de sortie 22b au port d'entrée 22a se présentent avantageusement sous la forme d'un étage à bascule à transistors. Le principe de fonctionnement de la bascule illustrée par la figure 2 est analogue à celui de la bascule illustrée par la figure 1, et est considéré comme connu de l'homme de l'art.

Par rapport à l'étage à bascule illustré sur la figure 1, celui illustré par la figure 2 se distingue toutefois par l'utilisation de transistors bipolaires T1, T2, T3, T4, et non de transistors MOSFET. Ceci est particulièrement adapté à une application dans le domaine spatial, dans la mesure où les transistors bipolaires sont plus résistants aux radiations, subies en environnement nucléaire. En outre il n'existe pas de transistors MOSFET durcis de très petit calibre (charge totale d'électrode de grille inférieure à 1 nano-coulomb).

En outre, l'étage à bascule de la figure 2 comporte de préférence une première paire 220 de transistors T1 et T2 et une seconde paire 221 de transistors T3 et T4. Les première 220 et seconde 221 paires de transistors forment chacune un montage de type Sziklai. Dans la première paire 220, le transistor T1 est de type NPN, tandis que le transistor T2 est de type PNP. Dans la seconde paire 221, le transistor T3 est de type NPN, tandis que le transistor T4 est de type PNP.

Suivant d'autres modes de réalisation non illustrés par des figures, les première 220 et seconde 221 paires de transistors forment chacune un montage de type Darlington.

De telles dispositions sont particulièrement avantageuses dans le cas d'une utilisation dans un environnement nucléaire. En effet, il n'est pas rare que le gain d'un transistor bipolaire, soumis à des radiations, diminue sensiblement au cours du temps. L'utilisation de paires de transistors en montage Sziklai ou Darlington permet d'augmenter le gain introduit par rapport au gain de chaque transistor d'une paire, afin d'assurer un gain suffisant jusqu'à la fin de la mission, en tenant compte des effets des radiations.

Dans le mode préféré de réalisation illustré par la figure 2, l'étage de connexion/déconnexion 22 comporte en outre deux ponts diviseurs de tension, un premier pont diviseur de tension comportant deux résistances R1 et R2, et un second pont diviseur de tension comportant deux résistances R3 et R4.

Le premier pont diviseur de tension est agencé, par rapport à la première paire 220 de transistors T1, T2, de sorte à augmenter la valeur absolue de la tension requise aux bornes de l'enroulement secondaire 211 pour placer la première paire 220 de transistors dans un état passant et ainsi connecter le port de sortie 22b de l'étage de connexion/déconnexion 22 à son port d'entrée 22a. Les valeurs des résistances R1 et R2 sont aptes à assurer que ladite connexion ne s'effectue que si la tension aux bornes de l'enroulement secondaire 211 est de valeur absolue supérieure à une valeur seuil prédéfinie. Les valeurs des résistances R1 et R2 sont également aptes à assurer une protection du transistor T2 lorsque que la seconde paire 221 de transistors est commandée, en assurant qu'une tension entre une électrode de base B2 et une électrode d'émetteur E2 du transistor T2 est inférieure à une valeur seuil prédéfinie.

De manière analogue, le second pont diviseur de tension est agencé, par rapport à la seconde paire 221 de transistors T3, T4, de sorte à augmenter la valeur absolue de la tension requise aux bornes de l'enroulement secondaire 211 pour placer la seconde paire 221 de transistors dans un état passant et ainsi connecter le port de sortie 22b de l'étage de connexion/déconnexion 22 à son port d'entrée 22a. Les valeurs des résistances R3 et R4 sont en outre aptes à assurer que ladite connexion ne s'effectue que si la tension aux bornes de l'enroulement secondaire 211 est de valeur absolue supérieure à une valeur seuil prédéfinie, pouvant être la même que celle pour placer la première paire 220 de transistors dans un état passant. Les valeurs des résistances R3 et R4 sont également aptes à assurer une protection du transistor T4 lorsque que la première paire 220 de transistors est commandée, en assurant qu'une tension entre une électrode de base B4 et une électrode d'émetteur E4 du transistor T4 est inférieure à une valeur seuil prédéfinie.

Du fait du premier pont diviseur et du second pont diviseur, le circuit de commande 20 présente une robustesse améliorée à d'éventuelles perturbations présentes au niveau de l'enroulement secondaire 211. En effet, ces perturbations n'influenceront la connexion/déconnexion du port de sortie 22b que si elles sont importantes, supérieures en valeur absolue à la valeur seuil requise pour déclencher la connexion dudit port de sortie 22b.

L'étage de connexion/déconnexion 22 peut également comporter d'autres composants.

Dans l'exemple non limitatif illustré par la figure 2, ledit étage de connexion/déconnexion 22 comporte des résistances R5, R6, R7 et R8, et des diodes D1 et D2. Les résistances R5 et R7 permettent d'amortir d'éventuelles oscillations générées par un circuit oscillant formé par une inductance de fuite du transformateur 21 et par un condensateur d'entrée d'un second étage, décrit ci-après, couplé au port de sortie 22b de l'étage de connexion/déconnexion 22. Les résistances R6 et R8 permettent d'accélérer le passage dans un état non-passant des transistors T1 et T3. Les diodes D1 et D2 ont sensiblement les mêmes fonctions que les diodes D1 et D2 décrites en référence à la figure 1.

Le circuit de commande 20 selon l'invention comporte également, en sortie de l'étage de connexion/déconnexion 22, un second étage, dit « étage de mémorisation » 23.

L'étage de mémorisation 23 comporte :
- un port d'entrée 23a couplé au port de sortie 22b de l'étage de connexion/déconnexion 22, et
- un port de sortie 23b couplé au circuit à commander, en l'occurrence le transistor de puissance Tp.

L'étage de mémorisation 23 comporte en outre :
- des moyens de mémoriser au moins temporairement, pendant une déconnexion de l'étage de connexion/déconnexion 22, un signal appliqué par ledit étage de connexion/déconnexion sur le port d'entrée 23a de l'étage de mémorisation 23 juste avant ladite déconnexion, et
- des moyens d'appliquer, sur le port de sortie 23b de l'étage de mémorisation 23, un signal de commande associé au signal mémorisé tant que ledit signal est mémorisé sur ledit port d'entrée.

On note dès à présent que, la mémorisation du signal appliqué par l'étage de connexion/déconnexion 22, en l'occurrence la valeur de la tension appliquée, s'effectue donc dans un étage spécifique du circuit de commande 20, en l'occurrence l'étage de mémorisation 23, et non plus sur le transistor de puissance Tp comme c'était le cas dans l'art antérieur décrit en référence à la figure 1.

Dans le mode préféré de réalisation illustré par la figure 2, les moyens de mémoriser et les moyens d'appliquer de l'étage de mémorisation 23 sont confondus et comportent deux transistors MOSFET, dits « transistors de mémorisation », en l'occurrence un premier transistor de mémorisation Tm1 de type N et un second transistor de mémorisation Tm2 de type P.

Le premier transistor de mémorisation Tm1 comporte de manière conventionnelle une électrode de grille Gm1, une électrode de source Sm1 et une électrode de drain Dm1.

De manière analogue, le second transistor de mémorisation Tm2 comporte de manière conventionnelle une électrode de grille Gm2, une électrode de source Sm2 et une électrode de drain Dm2.

Le premier transistor de mémorisation Tm1 (de type N) et le second transistor de mémorisation Tm2 (de type P) sont avantageusement agencés de sorte leurs électrodes de grille Gm1 et Gm2 sont reliées directement entre elles, et de sorte que leurs électrodes de source Sm1 et Sm2 sont également reliées directement entre elles.

En outre, les électrodes de grille Gm1, Gm2 des premier et second transistors de mémorisation Tm1 et Tm2 forment une première borne du port d'entrée 23a de l'étage de mémorisation 23, couplée à la première paire 220 de transistors de l'étage de connexion/déconnexion 22. Les électrodes de source Sm1, Sm2 des premier et second transistors de mémorisation Tm1 et Tm2 forment une seconde borne du port d'entrée 23a de l'étage de mémorisation 23, couplée à la seconde paire 221 de transistors de l'étage de connexion/déconnexion 22.

Du fait de cet agencement, on comprend que le port d'entrée 23a de l'étage de mémorisation 23 présente une impédance d'entrée élevée et capacitive, du fait des condensateurs grille-source du premier transistor de mémorisation Tm1 et du second transistor de mémorisation Tm2. Cette impédance d'entrée élevée permet de mémoriser une valeur d'une tension appliquée par l'étage de connexion/déconnexion 22 sur le port d'entrée 23a de l'étage de mémorisation 23 juste avant la déconnexion. En effet, lorsque le port de sortie 22b de l'étage de connexion/déconnexion 22 est déconnecté du port d'entrée 22a dudit étage de connexion/déconnexion, les condensateurs grille-source du premier transistor de mémorisation Tm1 et du second transistor de mémorisation Tm2 ne peuvent théoriquement plus se décharger.

En outre, le port de sortie 23b de l'étage de mémorisation 23 est couplé aux électrodes de source Sm1, Sm2 des premier et second transistors de mémorisation Tm1 et Tm2. Le port de sortie 23b de l'étage de mémorisation 23 est couplé à une électrode de grille Gp du transistor de puissance Tp.

La tension appliquée par l'étage de connexion/déconnexion 22 suite à une impulsion de commande générée par le circuit générateur 30 va permettre de placer dans un état passant (commutateur fermé) soit le premier transistor de mémorisation Tm1 soit le second transistor de mémorisation Tm2, de sorte que le signal de commande appliqué sur le port de sortie 23b de l'étage de mémorisation 23 sera soit sensiblement le potentiel de l'électrode de drain Dm1 du premier transistor de mémorisation Tm1 (si le premier transistor de mémorisation Tm1 est dans un état passant), soit sensiblement le potentiel de l'électrode de drain Dm2 du second transistor de mémorisation Tm2 (si le second transistor de mémorisation Tm2 est dans un état passant). Lesdits premier et second transistors de mémorisation Tm1 et Tm2 forment donc bien des moyens d'appliquer un signal de commande associé à la valeur de la tension mémorisée sur le port d'entrée 23a de l'étage de mémorisation 23, tant que ladite valeur de la tension est mémorisée sur ledit port d'entrée.

On comprend que, en pratique, la mémorisation est temporaire, dans la mesure où les condensateurs grille-source des premier et second transistors de mémorisation Tm1 et Tm2 vont avoir tendance à se décharger lentement.

Dans le contexte de l'invention, on considère que la valeur de la tension sur le port d'entrée 23a de l'étage de mémorisation 23 est effectivement mémorisée tant qu'elle est supérieure en valeur absolue à une valeur seuil prédéfinie par le fabricant des transistors de mémorisation Tm1 et Tm2, adaptée à maintenir le premier transistor de mémorisation Tm1 (ou le second transistor de mémorisation Tm2) dans un état passant.

Ainsi, suite à une déconnexion par l'étage de connexion/déconnexion 22, la valeur de la tension va être mémorisée mais va avoir tendance à diminuer lentement. En pratique, s'il est nécessaire de maintenir le transistor de puissance Tp dans un état passant ou non-passant pendant une durée risquant d'entraîner une décharge trop importante des condensateurs grille-source des premier et second transistors de mémorisation Tm1, Tm2, le circuit générateur 30 d'impulsions de commande pourra générer des impulsions de commande dites « de rafraîchissement » avec une périodicité suffisante pour assurer que la valeur de la tension mesurée ne devienne pas inférieure en valeur absolue à la valeur seuil prédéfinie assurant le maintien du premier transistor de mémorisation Tm1 (ou du second transistor de mémorisation Tm2) dans un état passant.

Les électrodes de drain Dm1, Dm2 des premier et second transistors de mémorisation Tm1 et Tm2 forment un port d'alimentation 23c pouvant être couplé à une ou plusieurs sources d'alimentation électrique pour générer des signaux de commande adaptés à commuter le transistor de puissance Tp.

Dans le mode préféré de réalisation illustré par la figure 2, deux sources d'alimentation électrique sont prévues : une première source d'alimentation électrique 24 et une seconde source d'alimentation électrique 25.

La première source d'alimentation électrique 24 comporte une première borne et une seconde borne entre lesquelles une tension égale par exemple à 15 Volts est délivrée, le potentiel électrique de la première borne étant plus élevé que celui de la seconde borne de ladite première source d'alimentation électrique 24.

La seconde source d'alimentation électrique 25 comporte une première borne et une seconde borne entre lesquelles une tension égale par exemple à 7.5 Volts est délivrée, le potentiel électrique de la première borne étant plus élevé que celui de la seconde borne de ladite seconde source d'alimentation électrique 25.

La première borne de la première source d'alimentation électrique 24 est couplée à l'électrode de drain Dm1 du premier transistor de mémorisation Tm1. La seconde borne de la seconde source d'alimentation électrique 25 est couplée à l'électrode de drain Dm2 du second transistor de mémorisation Tm2.

La seconde borne de la première source d'alimentation électrique 24 est couplée à la première borne de la seconde source d'alimentation électrique 25, et le potentiel électrique de ces bornes constitue un potentiel de référence, désigné par Vr, auquel est également portée une électrode d'émetteur Ep du transistor de puissance Tp.

On comprend donc que, lorsque le premier transistor de mémorisation Tm1 est placé dans un état passant, le potentiel électrique appliqué sur le port de sortie 23b de l'étage de mémorisation 23 est délivré par la première source d'alimentation électrique 24, et la tension entre l'électrode de grille Gp et l'électrode d'émetteur Ep du transistor de puissance Tp est de l'ordre de 15 Volts, permettant de placer ledit transistor de puissance dans un état passant.

Lorsque le second transistor de mémorisation Tm2 est placé dans un état passant, le potentiel électrique appliqué sur le port de sortie 23b de l'étage de mémorisation 23 est délivré par la seconde source d'alimentation électrique 25, et la tension entre l'électrode de grille Gp et l'électrode d'émetteur Ep du transistor de puissance Tp est de l'ordre de -7.5 Volts, permettant de placer ledit transistor de puissance dans un état non-passant.

Il est à noter que les valeurs des tensions fournies par les première et seconde sources d'alimentation électrique 24 et 25 (respectivement 15 Volts et 7.5 Volts) sont données à titre illustratif uniquement. On comprend en effet que d'autres valeurs peuvent être considérées, et qu'un choix particulier de valeurs de tensions fournies ne constitue qu'une variante d'implémentation de l'invention. Rien n'exclut, en outre, de n'avoir qu'une source d'alimentation électrique 24, en couplant par exemple l'électrode de drain Dm2 du second transistor de mémorisation Tm2 au zéro de ladite source d'alimentation 24 unique.

Il est à noter également que, du fait que les premier et second transistors de mémorisation Tm1 et Tm2 sont respectivement de type N et de type P, et du fait de leur agencement particulier (électrodes de grille Gm1 et Gm2 reliées directement, électrodes de source Sm1 et Sm2 reliées directement), l'étage de mémorisation 23 ainsi formé est particulièrement adapté à la commande du transistor de puissance Tp avec une fréquence de commutation élevée.

En effet, cet agencement assure que les premier et second transistors de mémorisation Tm1 et Tm2 ne sont jamais simultanément dans un état passant. De la sorte, le circuit de commande 20 ne présente pas de phase de court-circuit comme c'est le cas dans de nombreux circuits de commande de l'art antérieur, phases de court-circuit qui entrainent une consommation électrique indésirable d'autant plus importante que la fréquence de commutation est élevée.

Suivant des modes particuliers de réalisation, non illustrés par des figures, l'étage de mémorisation 23 comporte en outre au moins un condensateur comportant une première borne couplée aux électrodes de grille Gm1, Gm2 des premier et second transistors de mémorisation, et une seconde borne couplée aux électrodes de source Sm1, Sm2 desdits premier et second transistors de mémorisation. De telles dispositions permettent d'augmenter la capacitance du port d'entrée 23a de l'étage de mémorisation 23, et par conséquent d'améliorer la faculté de mémorisation dudit port d'entrée 23a.

Il est à noter que tout transistor présentant une haute impédance d'entrée (adaptée à la mémorisation), se trouvant dans un état non-passant à tension de commande nulle et ayant un transistor complémentaire de telle sorte qu'une tension de commande permettant de placer l'un des transistors dans un état passant place nécessairement l'autre transistor dans un état non-passant (comme c'est le cas pour les transistors MOSFET de types complémentaires N et P), peut être mis en oeuvre dans l'étage de mémorisation 23 représenté sur la figure 2.

Dans des modes particuliers de réalisation, illustrés par la figure 2, l'étage de mémorisation 23 comporte au moins une résistance de valeur suffisante pour assurer qu'une durée de charge ou de décharge du transistor de puissance Tp est égale ou supérieure à une durée minimale prédéfinie.

Dans l'exemple illustré par la figure 2, l'étage de mémorisation 23 comporte une résistance Rm entre d'une part les électrodes de source Sm1, Sm2 des premier et second transistors de mémorisation Tm1 et Tm2, et d'autre part l'électrode de grille Gp du transistor de puissance Tp.

Rien n'exclut, suivant d'autres exemples non illustrés par des figures, d'avoir au moins deux résistances : une première résistance entre l'électrode de drain Dm1 du premier transistor de mémorisation Tm1 et la première source d'alimentation électrique 24, et une seconde résistance entre l'électrode de drain Dm2 du second transistor de mémorisation Tm2 et la seconde source d'alimentation électrique 25. L'utilisation de deux résistances ainsi positionnées permet, dans le cas de résistances de valeurs différentes, d'avoir des durées minimales prédéfinies différentes pour la charge du transistor de puissance Tp et pour la décharge dudit transistor de puissance.

Rien n'exclut en outre, suivant d'autres exemples non illustrés par des figures, d'avoir, pour contrôler la commutation du transistor de puissance Tp, d'autres dispositifs que la (ou les) résistance(s) Rm. Suivant un exemple non limitatif, particulièrement adapté à la commande d'un transistor de puissance Tp du type MOSFET ou IGBT de grandes dimensions, la résistance Rm est remplacée par une commande en courant résonnante, par exemple du type décrit dans la demande US 2010/0019807.

La figure 3 représente un chronogramme illustrant le fonctionnement du circuit de commande 20.

La partie a) de la figure 3 représente schématiquement la tension Ve1 au niveau de l'enroulement primaire 210 du transformateur 21.

Dans cette partie a), quatre impulsions de commande, de même durée ΔT, sont reçues au niveau de l'enroulement primaire 210 :
- une impulsion de commande de valeur -V0 à un instant T1,
- une impulsion de commande de valeur +V0 à un instant T2,
- une impulsion de commande de valeur -V0 à un instant T3,
- une impulsion de commande de valeur +V0 à un instant T4.

La partie b) de la figure 3 représente schématiquement la tension Vgs sur le port d'entrée 23a de l'étage de mémorisation 23, c'est-à-dire entre, d'une part, les électrodes de grille Gm1, Gm2 des premier et second transistors de mémorisation Tm1 et Tm2 et, d'autre part, les électrodes de source Sm1, Sm2 desdits premier et second transistors de mémorisation. On suppose de manière non limitative qu'une tension Ve1 de valeur +V0 induit une tension Vgs de valeur également +V0, et qu'une tension Ve1 de valeur -V0 induit une tension Vgs de valeur également -V0.

Dans cette partie b), la tension Vgs prend une valeur sensiblement également à -V0 rapidement après l'instant T1, et ce jusqu'à l'instant T2. Entre l'instant T1+ΔT et l'instant T2, l'étage de connexion/déconnexion 22 est déconnecté et la valeur de la tension Vgs est mémorisée sur le port d'entrée 23a de l'étage de mémorisation 23.

La tension Vgs prend une valeur sensiblement également à +V0 rapidement après l'instant T2, et ce jusqu'à l'instant T3. Entre l'instant T2+ΔT et l'instant T3, l'étage de connexion/déconnexion 22 est déconnecté et la valeur de la tension Vgs est mémorisée sur le port d'entrée 23a de l'étage de mémorisation 23.

La tension Vgs prend une valeur sensiblement également à -V0 rapidement après l'instant T3, et ce jusqu'à l'instant T4. Entre l'instant T3+ΔT et l'instant T4, l'étage de connexion/déconnexion 22 est déconnecté et la valeur de la tension Vgs est mémorisée sur le port d'entrée 23a de l'étage de mémorisation 23, etc.

La partie c) de la figure 3 représente schématiquement la tension Vge entre l'électrode de grille Gp et l'électrode d'émetteur Ep du transistor de puissance Tp. On suppose de manière non limitative qu'une tension Vgs de valeur +V0 induit une tension Vge de valeur +15 Volts, et qu'une tension Vgs de valeur -V0 induit une tension Vge de valeur -7.5 Volts.

Dans cette partie c), la tension Vge prend une valeur sensiblement également à -7.5 Volts peu après l'instant T1.

La tension Vge prend une valeur sensiblement également à +15 Volts peu après l'instant T2, puis une valeur sensiblement également à -7.5 Volts peu après l'instant T3, puis une valeur sensiblement également à +15 Volts peu après l'instant T4, etc.

De manière générale, on constate sur la partie b) et la partie c) de la figure 3 que le transistor de puissance Tp se charge et se décharge plus lentement que les premier et second transistors de mémorisation Tm1 et Tm2.

La description ci-avant illustre clairement que par ses différentes caractéristiques et leurs avantages, la présente invention atteint les objectifs qu'elle s'était fixés.

En particulier, du fait que la mémorisation s'effectue sur l'étage de mémorisation 23 et non sur le transistor de puissance Tp comme c'était le cas dans l'art antérieur décrit en référence à la figure 1, le circuit de commande 20 selon l'invention peut être mis en oeuvre pour commander la commutation de tout type de transistor de puissance (bipolaire, à effet de champ, à grille isolée - MOSFET, IGBT, etc. -, etc.).

De plus, l'étage de mémorisation 23 comporte avantageusement des transistors de taille inférieure à celle des transistors de puissance à commander, de sorte qu'ils sont faciles et rapides à commuter, et de sorte que la commutation de l'étage de mémorisation 23 est indépendante du transistor de puissance Tp piloté. Par conséquent, les impulsions de commande peuvent être plus courtes que dans l'art antérieur décrit en référence à la figure 1, par exemple de l'ordre de quelques dizaines de nanosecondes à quelques centaines de nanosecondes. En réduisant la durée des impulsions, les dimensions requises pour le transformateur 21 peuvent être réduites, de même que le nombre de spires requises au niveau de chaque enroulement. En réduisant les dimensions requises pour le transformateur 21, celui-ci peut avantageusement être sans noyau et intégrable directement sur un même circuit imprimé que les autres composants du circuit de commande 20. En réduisant le nombre de spires du transformateur 21, on réduit également le couplage entre l'enroulement primaire 210 et l'enroulement secondaire 211, ce qui améliore l'immunité en mode commun primaire/secondaire. Afin d'améliorer cette immunité, le transformateur 21 comporte de préférence un écran en matériau conducteur, agencé entre l'enroulement primaire 210 et l'enroulement secondaire 211, et porté à un potentiel de référence tel que le potentiel Vr.

Ce n'est pas la largeur des impulsions de commande qui définit la durée du signal de commande appliqué au transistor de puissance Tp mais l'espacement dans le temps entre deux impulsions de commande de valeur respectivement +V0 (transistor de puissance Tp dans un état passant) et -V0 (transistor de puissance Tp dans un état non-passant). De ce fait et comme les impulsions de commande de valeur +V0/-V0 ont la même durée, une impulsion de commande de valeur +V0 peut être immédiatement suivie par une impulsion de commande -V0 sans que cela ne pose problème au transformateur 21 de commande puisque celui-ci sera magnétisé autant qu'il sera démagnétisé. Ainsi les signaux de commande de Tp ne sont pas contraints ni dans leur durée, ni dans leur récurrence par la prise en compte de l'état magnétique du transformateur 21.

Du fait de la structure particulière de l'étage de mémorisation 23 illustrée par la figure 2, les phases de court-circuit sont supprimées lors des commutations, de sorte que le circuit de commande 20 est particulièrement adapté à une utilisation pour des fréquences de commutation élevées.

Le circuit de commande 20 peut être réalisé exclusivement avec des composants discrets, et ce en nombre réduit, ce qui en rend le durcissement plus facile, et rend ce circuit de commande 20 particulièrement adapté pour des applications en environnement nucléaire.

Les commandes et la puissance nécessaire pour effectuer ces commandes sont en outre passées par des canaux différents. En effet, les commandes sont passées par le transformateur 21 et l'étage de connexion/déconnexion 22, et mémorisées par l'étage de mémorisation 23. La puissance nécessaire pour commuter le transistor de puissance Tp est quand à elle fournie par les sources d'alimentation électrique 24 et 25. Par conséquent, le même circuit de commande 20 peut être utilisé pour commander des transistors de puissance différents, seules les sources d'alimentation électrique devant le cas échéant être changées pour être adaptées aux caractéristiques du transistor de puissance à commander.

De manière plus générale, le circuit de commande 20 selon l'invention peut être mis en oeuvre pour commander de nombreux types de circuits électriques de puissance, y compris des transistors de puissance, des alimentations à découpage, des onduleurs, etc.

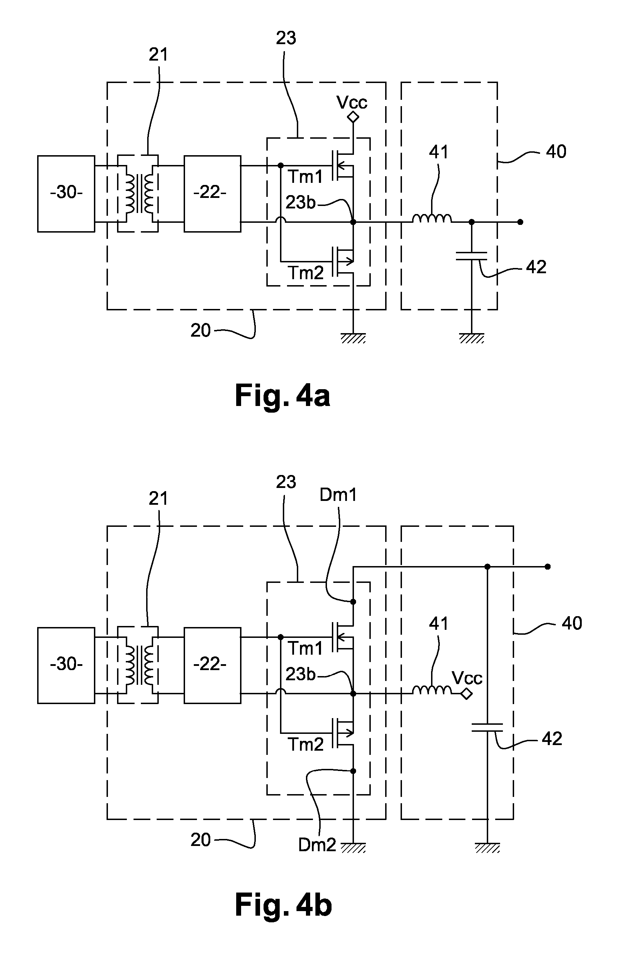

Les figures 4a et 4b représentent schématiquement des dispositifs électriques dans lesquels le circuit de commande 20 est mis en oeuvre pour commander une alimentation à découpage 40.

Dans la figure 4a, le circuit de commande 20 est mis en oeuvre pour commander une alimentation à découpage 40 de type hacheur abaisseur (« Buck » dans la littérature anglo-saxonne) représentée comme comportant principalement, et de manière conventionnelle, une bobine 41 et un condensateur 42.

Dans cet exemple, l'électrode de drain Dm2 de second transistor de mémorisation Tm2 est reliée directement à la masse électrique, tandis que l'électrode de drain Dm1 du premier transistor de mémorisation Tm1 est reliée directement à une source d'alimentation électrique délivrant une tension Vcc.

Le port de sortie 23b de l'étage de mémorisation 23 (c'est-à-dire les électrodes de source Sm1, Sm2 des premier et second transistors de mémorisation Tm1 et Tm2) est relié directement à une borne de la bobine 41 de l'alimentation à découpage 40, la seconde borne de ladite bobine 41 étant le port de sortie de ladite alimentation à découpage 40. Le condensateur 42 est relié à la fois à la seconde borne de la bobine 41 et à la masse électrique.

Dans la figure 4b, le circuit de commande 20 est mis en oeuvre pour commander une alimentation à découpage 40 de type hacheur élévateur (« Boost » dans la littérature anglo-saxonne) représentée comme comportant principalement, et de manière conventionnelle, une bobine 41 et un condensateur 42.

Par rapport à l'exemple illustré par la figure 4a :
- le port de sortie de l'alimentation à découpage 40 est dans cet exemple relié à l'électrode de drain Dm1 du premier transistor de mémorisation Tm1,
- la seconde borne de la bobine 41 est reliée directement à la source d'alimentation électrique délivrant une tension Vcc,
- le condensateur 42 est relié à la fois à l'électrode de drain Dm1 du premier transistor de mémorisation Tm1 et à la masse électrique.

## Revendications

1. Circuit de commande (20) d'un circuit électrique de puissance, dit « circuit à commander » (Tp, 40), comportant un étage, dit « étage de connexion/déconnexion » (22), comportant :
- un port d'entrée (22a), destiné à être couplé à un circuit générateur (30) d'impulsions de commande pouvant prendre au moins deux valeurs prédéfinies associées à des signaux de commande distincts à appliquer au circuit à commander,
- un port de sortie (22b),
- des moyens configurés pour connecter son port de sortie (22b) à son port d'entrée (22a) lorsqu'une impulsion de commande est appliquée sur ledit port d'entrée (22a), et configurés pour déconnecter son port de sortie (22b) de son port d'entrée (22a) lorsqu'aucune impulsion de commande n'est appliquée sur ledit port d'entrée (22a),
**caractérisé en ce que** le circuit de commande (20) comporte un étage, dit « étage de mémorisation » (23), comportant :
- un premier transistor MOSFET (Tm1) et un second transistor MOSFET (Tm2), respectivement de type N et de type P, des électrodes de grille desdits premier et second transistors MOSFET étant reliées directement entre elles, et des électrodes de source desdits premier et second transistors MOSFET étant reliées directement entre elles,
- un port d'entrée (23a), couplé au port de sortie (22b) de l'étage de connexion/déconnexion (22), comportant deux bornes dont l'une est couplée aux électrodes de grille et l'autre est couplée aux électrodes de source des premier et second transistors MOSFET,
- un port de sortie destiné à être couplé au circuit à commander, de sorte que, pendant une déconnexion de l'étage de connexion/déconnexion (22) :
- un signal appliqué par ledit étage de connexion/déconnexion juste avant ladite déconnexion est mémorisé sur le port d'entrée (23a) de l'étage de mémorisation (23),
- un signal de commande, associé au signal mémorisé et reçu par des électrodes de drain des premier et second transistors MOSFET (Tm1, Tm2), est appliqué sur le port de sortie (23b) de l'étage de mémorisation (23) tant que ledit signal est mémorisé.

2. Circuit de commande (20) selon la revendication 1, **caractérisé en ce que** l'étage de mémorisation (23) comporte au moins un condensateur comportant deux bornes couplées respectivement aux électrodes de grille et aux électrodes de source desdits premier et second transistors MOSFET (Tm1, Tm2).

3. Circuit de commande (20) selon l'une des revendications précédentes, **caractérisé en ce que** l'étage de connexion/déconnexion (22) est un étage à bascule à base de transistors.

4. Circuit de commande (20) selon la revendication 3, **caractérisé en ce que** l'étage à bascule comporte deux montages de transistors de type Sziklai ou Darlington.

5. Circuit de commande (20) selon l'une des revendications 3 à 4, **caractérisé en ce que** l'étage à bascule comporte deux ponts diviseurs de tension, chaque pont diviseur étant adapté à ne permettre la connexion de l'étage de mémorisation (23) que si la tension sur le port d'entrée (22a) de l'étage de connexion/déconnexion (22) est de valeur absolue supérieure à une valeur seuil prédéfinie.

6. Cirduit de commande (20) selon l'une des revendications 3 à 5, **caractérisé en ce que** l'étage à bascule est à base de transistors bipolaires.

7. Circuit de commande (20) selon l'une des revendications précédentes, **caractérisé en ce que** l'étage de mémorisation (23) comporte un port d'alimentation (23c), formé par les électrodes de drain des premier et second transistors MOSFET (Tm1, Tm2), destiné à être couplé à au moins une source d'alimentation électrique (24, 25) pour la formation des signaux de commande à appliquer au circuit à commander.

8. Circuit de commande (20) selon l'une des revendications précédentes, **caractérisé en ce qu'**il comporte un transformateur (21) comportant au moins un enroulement primaire (210) destiné à être couplé au circuit générateur (30) d'impulsions de commande, et un enroulement secondaire (211) couplé au port d'entrée (22a) de l'étage de connexion/déconnexion (22).

9. Dispositif électrique comportant un circuit générateur (30) d'impulsions de commande, un circuit électrique de puissance, dit « circuit à commander », **caractérisé en ce qu'**il comporte un circuit de commande (20) selon l'une des revendications précédentes.

10. Dispositif électrique selon la revendication 9, **caractérisé en ce que** le circuit à commander est du type comportant au moins un transistor de puissance (Tp) mis en oeuvre comme commutateur, dont l'ouverture et la fermeture sont commandées par le circuit de commande (20).

11. Dispositif électrique selon la revendication 10, **caractérisé en ce que** le transistor de puissance (Tp) est un transistor à grille isolée, et **en ce que** l'étage de mémorisation (23) comporte au moins un composant résistif de valeur suffisante pour assurer qu'une durée de charge ou de décharge dudit transistor de puissance (Tp) est égale ou supérieure à une durée minimale prédéfinie de contrôle de la commutation dudit transistor de puissance.

12. Dispositif électrique selon la revendication 9, **caractérisé en ce que** le circuit à commander est une alimentation à découpage (40).

## Patentansprüche

1. Steuerungsschaltkreis (20) eines elektrischen Leistungsschaltkreises, "zu steuernder Schaltkreis" (Tp, 40) genannt, umfassend eine Stufe, "Anschluss-/Trennstufe" (22) genannt, umfassend:
- einen Eingangsport (22a), der dazu bestimmt ist, an einen Schaltkreis (30) zur Erzeugung von Steuerungsimpulsen gekoppelt zu werden, der zumindest zwei vordefinierte Werte annehmen kann, die unterschiedlichen Steuerungssignalen, die an den Steuerungsschaltkreis angelegt werden können, zugeordnet sind,
- einen Ausgangsport (22b),
- Mittel, die derart konfiguriert sind, dass sie seinen Ausgangsport (22b) mit seinem Eingangsport (22a) verbinden, wenn ein Steuerungsimpuls an den Eingangsport (22a) angelegt wird, und die derart konfiguriert sind, dass sie seinen Ausgangsport (22b) von seinem Eingangsport (22a) trennen, wenn ein Steuerungsimpuls an den Eingangsport (22a) angelegt wird,
**dadurch gekennzeichnet, dass** der Steuerungsschaltkreis (20) eine Stufe, "Speicherstufe" (23) genannt, umfasst, umfassend:
- einen ersten MOSFET-Transistor (Tm1) und einen zweiten MOSFET-Transistor (Tm2), des Typs N bzw. des Typs P, wobei Gate-Elektroden der ersten und zweiten MOSFET-Transistoren direkt miteinander verbunden sind, und Quellenelektroden der ersten und zweiten MOSFET-Transistoren direkt miteinander verbunden sind,
- einen Eingangsport (23a), der an den Ausgangsport (22b) der Anschluss-/Trennstufe (22) gekoppelt ist, umfassend zwei Klemmen, von denen eine an die Gate-Elektroden und die andere an die Quellenelektroden der ersten und zweiten MOSFET-Transistoren gekoppelt ist,
- einen Ausgangsport, der dazu bestimmt ist, an den zu steuernden Schaltkreis gekoppelt zu werden,
so dass während einer Trennung der Anschluss-/Trennstufe (22):
- ein von der Anschluss-/Trennstufe direkt vor der Trennung angelegtes Signal am Eingangsport (23a) der Speicherstufe (23) gespeichert wird,
- ein Steuerungssignal, das dem gespeicherten und von den Drain-Elektroden der ersten und zweiten MOSFET-Transistoren (Tm1, Tm2) empfangenen Signal zugeordnet ist, an den Ausgangsport (23b) der Speicherstufe (23) angelegt wird, solange das Signal gespeichert ist.

2. Steuerungsschaltkreis (20) nach Anspruch 1, **dadurch gekennzeichnet, dass** die Speicherstufe (23) mindestens einen Kondensator aufweist, umfassend zwei Klemmen, die an die Gate-Elektroden bzw. die Quellenelektroden der ersten und zweiten MOSFET-Transistoren (Tm1, Tm2) gekoppelt sind.

3. Steuerungsschaltkreis (20) nach einem der vorhergehenden Ansprüche, **dadurch gekennzeichnet, dass** die Anschluss-/Trennstufe (22) eine Kippstufe auf Transistorbasis ist.

4. Steuerungsschaltung (20) nach Anspruch 3, **dadurch gekennzeichnet, dass** die Kippstufe zwei Transistormontagen des Typs Sziklai oder Darlington umfasst.

5. Steuerungsschaltkreis (20) nach einem der Ansprüche 3 bis 4, **dadurch gekennzeichnet, dass** die Kippstufe zwei Spannungsteilerbrücken umfasst, wobei jede Teilerbrücke dazu vorgesehen ist, den Anschluss der Speicherstufe (23) nur dann zu ermöglichen, wenn die Spannung am Eingangsport (22a) der Anschluss-/Trennstufe (22) im Absolutwert höher als ein vordefinierter Schwellenwert ist.

6. Steuerungsschaltkreis (20) nach einem der Ansprüche 3 bis 5, **dadurch gekennzeichnet, dass** die Kippstufe auf Basis von bipolaren Transistoren ist.

7. Steuerungsschaltkreis (20) nach einem der vorhergehenden Ansprüche, **dadurch gekennzeichnet, dass** die Speicherstufe (23) einen Versorgungsport (23c) umfasst, der von den Drain-Elektroden der ersten und zweiten MOSFET-Transistoren (Tm1, Tm2) gebildet und dazu bestimmt ist, mit mindestens einer elektrischen Versorgungsquelle (24, 25) zur Bildung der an den zu steuernden Schaltkreis anzulegenden Steuerungssignale gekoppelt zu werden.

8. Steuerungsschaltkreis (20) nach einem der vorhergehenden Ansprüche, **dadurch gekennzeichnet, dass** er einen Transformator (21) aufweist, umfassend mindestens eine Primärwicklung (210), die dazu bestimmt ist, mit dem Schaltkreis (30) zur Erzeugung von Steuerungsimpulsen gekoppelt zu werden, und eine Sekundärwicklung (211), die mit dem Eingangsport (22a) der Anschluss-/Trennstufe (22) gekoppelt ist.

9. Elektrische Vorrichtung, umfassend einen Schaltkreis (30) zur Erzeugung von Steuerungsimpulsen, einen elektrischen Leistungsschaltkreis, "zu steuernder Schaltkreis" genannt, **dadurch gekennzeichnet, dass** sie einen Steuerungsschaltkreis (20) nach einem der vorhergehenden Ansprüche umfasst.

10. Elektrische Vorrichtung nach Anspruch 9, **dadurch gekennzeichnet, dass** der zu steuernde Schaltkreis von dem Typ ist, umfassend mindestens einen Leistungstransistor (Tp), der als Umschalter eingesetzt wird, dessen Öffnen und Schließen von dem Steuerungsschaltkreis (20) gesteuert werden.

11. Elektrische Vorrichtung nach Anspruch 10, **dadurch gekennzeichnet, dass** der Leistungstransistor (Tp) ein Transistor mit isoliertem Gate ist, und dass die Speicherstufe (23) mindestens eine Widerstandskomponente mit ausreichendem Wert hat, um sicherzustellen, dass eine Lade- oder Entladedauer des Leistungstransistors (Tp) gleich oder größer als eine vordefinierte Mindestdauer der Kontrolle der Umschaltung des Leistungstransistors ist.

12. Elektrische Vorrichtung nach Anspruch 9, **dadurch gekennzeichnet, dass** der zu steuernde Schaltkreis ein Schaltnetzteil (40) ist.

## Claims

1. Control circuit (20) for controlling an electrical power circuit, termed the "circuit to be controlled" (Tp, 40), comprising a stage, termed the "connection/disconnection stage" (22), comprising:
- an input port (22a), intended to be coupled to a generator circuit (30) for generating control pulses able to take at least two predefined values associated with distinct control signals to be applied to the circuit to be controlled,
- an output port (22b),
- means configured to connect its output port (22b) to its input port (22a) when a control pulse is applied to said input port (22a), and configured to disconnect its output port (22b) from its input port (22a) when no control pulse is applied to said input port (22a), **characterized in that** the control circuit (20) comprises a stage, termed the "storage stage" (23), comprising:
- a first MOSFET transistor (Tm1) and a second MOSFET transistor (Tm2), respectively of N type and of P type, gate electrodes of said first and second MOSFET transistors being linked directly together, and source electrodes of said first and second MOSFET transistors being linked directly together,
- an input port (23a), coupled to the output port (22b) of the connection/disconnection stage (22), comprising two terminals, one of which is coupled to the gate electrodes and the other of which is coupled to the source electrodes of the first and second MOSFET transistors,
- an output port intended to be coupled to the circuit to be controlled,
so that, during a disconnection of the connection/disconnection stage (22):
- a signal applied by said connection/disconnection stage just before said disconnection is stored on the input port (23a) of the storage stage (23),
- a control signal, associated with the signal stored and received by drain electrodes of the first and second MOSFET transistors (Tm1, Tm2), is applied to the output port (23b) of the storage stage (23) as long as said signal is stored.

2. Control circuit (20) according to Claim 1, **characterized in that** the storage stage (23) comprises at least one capacitor comprising two terminals coupled respectively to the gate electrodes and to the source electrodes of said first and second MOSFET transistors (Tm1, Tm2).

3. Control circuit (20) according to one of the preceding claims, **characterized in that** the connection/disconnection stage (22) is a transistors-based flip-flop stage.

4. Control circuit (20) according to Claim 3, **characterized in that** the flip-flop stage comprises two setups of transistors of Sziklai or Darlington type.

5. Control circuit (20) according to one of Claims 3 and 4, **characterized in that** the flip-flop stage comprises two voltage-divider bridges, each divider bridge being adapted to allow the connection of the storage stage (23) only if the voltage on the input port (22a) of the connection/disconnection stage (22) is of greater absolute value than a predefined threshold value.

6. Control circuit (20) according to one of Claims 3 to 5, **characterized in that** the flip-flop stage is based on bipolar transistors.

7. Control circuit (20) according to one of the preceding claims, **characterized in that** the storage stage (23) comprises a power supply port (23c), formed by the drain electrodes of the first and second MOSFET transistors (Tm1, Tm2), which is intended to be coupled to at least one electrical power supply source (24, 25) for the formation of the control signals to be applied to the circuit to be controlled.

8. Control circuit (20) according to one of the preceding claims, **characterized in that** it comprises a transformer (21) comprising at least one primary winding (210) intended to be coupled to the generator circuit (30) for generating control pulses, and a secondary winding (211) coupled to the input port (22a) of the connection/disconnection stage (22).

9. Electrical device comprising a generator circuit (30) for generating control pulses, an electrical power circuit, termed the "circuit to be controlled", **characterized in that** it comprises a control circuit (20) according to one of the preceding claims.

10. Electrical device according to Claim 9, **characterized in that** the circuit to be controlled is of the type comprising at least one power transistor (Tp) implemented as a switch, whose opening and closing are controlled by the control circuit (20).

11. Electrical device according to Claim 10, **characterized in that** the power transistor (Tp) is an insulated-gate transistor, and **in that** the storage stage (23) comprises at least one resistive component of sufficient value to ensure that a duration of charging or of discharging of said power transistor (Tp) is equal to or greater than a predefined minimum duration of command of the switching of said power transistor.

12. Electrical device according to Claim 9, **characterized in that** the circuit to be controlled is a switched power supply (40).
